# EUROPEAN PATENT SPECIFICATION

(11) **EP 4 513 544 B1**
(45) Date of publication and mention of the grant of the patent: **10.09.2025**
(21) Application number: 24195620.0
(22) Date of filing: 21.08.2024
(51) Int. Cl.: H01L 23/00, H01L 23/538, H01L 25/065, H01L 23/373, H01L 25/07, H01L 23/433

(54) **SEMICONDUCTOR APPARATUS**
HALBLEITERVORRICHTUNG
APPAREIL À SEMI-CONDUCTEUR

(30) Priority: 24.08.2023 JP 2023136611
(43) Date of publication of application: 26.02.2025
(73) Proprietor: SHINKO ELECTRIC INDUSTRIES CO., LTD., Nagano-shi, Nagano 381-2287 (JP)
(72) Inventor: MURAYAMA, Kei, NAGANO, 381-2287 (JP)
(74) Representative: Regimbeau

(56) References cited:
- EP-A2- 0 938 138
- JP-A- 2022 034 300
- US-A1- 2015 061 100
- US-A1- 2016 126 212
- US-A1- 2020 161 271

## Description

### FIELD

The disclosures herein generally relate to semiconductor apparatuses.

### BACKGROUND

A power-system semiconductor apparatus (i.e., power module) as known in the art controls or supplies electric power. This type of semiconductor apparatus includes, for example, a plurality of semiconductor devices having respective gate electrodes, and the gate electrodes are electrically connected to each other to switch the plurality of semiconductor devices simultaneously (for example, see Patent Document 1). Other examples of semiconductor apparatus are disclosed in US 2015/061100 A1, EP 0938138 A2, US 2016/126212 A1 and JP 2022 034300 A.

When a plurality of semiconductor devices need to be simultaneously switched, aligning the timing of the switching operations presents a challenge.

Accordingly, there may be a need for a semiconductor apparatus which may reduce timing deviation when a plurality of semiconductor devices need to be simultaneously switched.

### [Related-Art Document]

### [Patent Document]

[Patent Document 1] Japanese Unexamined Patent Publication No. 2021-125546

### SUMMARY

According to an aspect of the embodiment, a semiconductor apparatus as defined in appended claim 1 is provided. Other embodiments are defined in the corresponding dependent claims.

### BRIEF DESCRIPTION OF DRAWINGS

FIGS. 1A and 1B are drawings illustrating a semiconductor apparatus according to a first embodiment;
FIGS. 2A through 2C are drawings illustrating a manufacturing process of a semiconductor apparatus according to the first embodiment;
FIGS. 3A and 3B are drawings illustrating the manufacturing process of a semiconductor apparatus according to the first embodiment;
FIGS. 4A and 4B are drawings illustrating a semiconductor apparatus according to a first variation of the first embodiment;
FIG. 5 is a plan view illustrating a semiconductor apparatus according to a second variation of the first embodiment not forming part of the invention;
FIG. 6 is a plan view illustrating a semiconductor apparatus according to a third variation of the first embodiment not forming part of the invention;
FIGS. 7A and 7B are drawings illustrating a semiconductor apparatus according to a fourth variation of the first embodiment not forming part of the invention; and
FIG. 8 is a plan view illustrating a semiconductor apparatus according to a fifth variation of the first embodiment not forming part of the invention.

### DESCRIPTION OF EMBODIMENTS

In the following, embodiments for carrying out the invention will be described with reference to the accompanying drawings. In these drawings, the same components are referred to by the same reference numerals, and a duplicate description thereof may be omitted.

### <First Embodiment>

### [Semiconductor Apparatus]

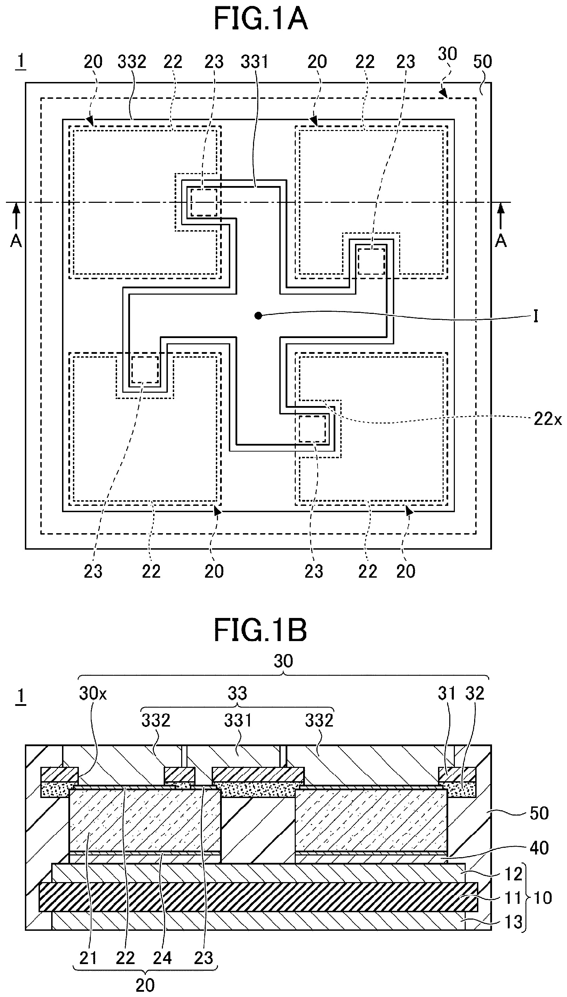

FIGS. 1A and 1B are drawings illustrating a semiconductor apparatus according to a first embodiment, FIG. 1A is a plan view, and FIG. 1B is a cross-sectional view taken along the line A-A in FIG. 1A.

Referring to FIGS. 1A and 1B, a semiconductor apparatus 1 includes an interconnect substrate 10, a plurality of semiconductor devices 20, an interconnect substrate 30, a joint 40, and an encapsulating resin 50. It suffices for the present invention to have 3 or more semiconductor devices. The first embodiment is directed to an example in which 4 semiconductor devices 20 are provided.

In the present embodiment, for the sake of convenience, the interconnect substrate 30 side of the semiconductor apparatus 1 is defined as an upper side, and the interconnect substrate 10 side is defined as a lower side. Further, the surface of a portion on the upper side is defined as an upper surface, and the surface of a portion on the lower side is defined as a lower surface. It should be noted, however, that the semiconductor apparatus 1 may be placed upside down when used, or may be arranged at an any angle. The plan view refers to the view of an object as seen from the direction normal to the upper surface of the interconnect substrate 30, and the plane shape refers to the shape of an object as viewed from the direction normal to the upper surface of the interconnect substrate 30.

The interconnect substrate 10 is formed in a flat plate shape. The interconnect substrate 10 may have any plane shape and any size. In the example illustrated in FIGS. 1A and 1B, the plane shape of the interconnect substrate 10 is rectangular.

The interconnect substrate 10 includes an insulating layer 11, a metal layer 12, and a metal layer 13. The coefficient of thermal expansion of the interconnect substrate 10 may be, for example, about 2 ppm/°C to 7 ppm/°C.

The insulating layer 11 may be formed of, for example, ceramics such as oxide-based ceramics or non-oxide-based ceramics. Examples of the oxide-based ceramics include aluminum oxide (Al₂O₃) and zirconia (ZrO₂). Examples of the non-oxide-based ceramics include aluminum nitride (AlN) and silicon nitride (Si₃N₄). The thickness of the insulating layer 11 may be, for example, about 200 µm to 400 µm.

The metal layer 12 is formed on the upper surface of the insulating layer 11. The metal layer 12 may have any pattern. The metal layer 12 may be formed as a solid, continuous structure. The metal layer 13 may be used for electrical connection as an interconnect layer. As the material of the metal layer 12, for example, copper or a copper alloy may be used. The thickness of the metal layer 12 may be, for example, about 100 µm to 800 µm. The coefficient of thermal expansion of the metal layer 12 may be, for example, about 15 ppm/°C to 18ppm/°C.

If necessary, a surface treatment layer may be formed on the surface (both the upper surface and the sides surfaces, or only the upper surface) of the metal layer 12. Examples of the surface treatment layer include a metal layer such as an Au layer, an Ni layer/Au layer, an Ni layer/Pd layer/Au layer, and an Ni layer/Ag layer. As the Au layer, Ni layer, Pd layer, and Ag layer, for example, a metal layer formed by an electroless plating method (i.e., electroless plating metal layer) may be used. The Au layer is a metal layer made of Au or Au alloy. The Ni layer is a metal layer made of Ni or Ni alloy. The Pd layer is a metal layer made of Pd or Pd alloy. The Ag layer is a metal layer made of Ag or Ag alloy.

The metal layer 13 is formed on the lower surface of the insulating layer 11. The metal layer 13 may have any pattern. The metal layer 13 may be formed as a solid, continuous structure. The metal layer 13 may extend, for example, over the entire lower surface of the insulating layer 11 except for the outer perimeter edge. The metal layer 13 may not be used for electrical connection. The metal layer 13 may be used, for example, as a reinforcing layer for suppressing warpage or the like of the interconnect substrate 10. The metal layer 13 may also be used as a heat dissipating member.

As the material of the metal layer 13, for example, copper or a copper alloy may be used. If necessary, the same surface treatment layer as previously described may be formed on the surface (both the lower surface and the side surfaces, or only the lower surface) of the metal layer 13. The thickness of the metal layer 13 may be, for example, about 100 µm to 800 µm. The thickness of the metal layer 13 may be, for example, the same as that of the metal layer 12 or thinner than that of the metal layer 12.

Each semiconductor device 20 is bonded to the upper surface of the metal layer 12 of the interconnect substrate 10 via the joint 40 which is electrically conductive. As the material of the joint 40, for example, a sintered metal material may be used. As the sintered material, for example, a sintered material mainly composed of silver (Ag) particles (i.e., silver sintering material) or a sintered material mainly composed of copper particles (i.e., copper sintering material) may be used. Alternatively, the material of the joint 40 may be, for example, a conductive paste such as solder or silver paste, or a metal brazing filler metal. The thickness of the joint 40 may be, for example, about 20 µm to 60 µm.

Each semiconductor device 20 is, for example, a power semiconductor device. Each semiconductor device 20 has a control electrode and is switched by a voltage applied to the control electrode. Examples of the semiconductor device 20 include an insulated gate bipolar transistor (IGBT), a metal-oxide-semiconductor field-effect transistor (MOSFET), a diode, and the like.

In the first embodiment, the semiconductor device 20 is a MOSFET. The plane shape of the semiconductor device 20 may be any shape with any size. The plane shape of the semiconductor device 20 is, for example, rectangular. The thickness of the semiconductor device 20 may be, for example, about 50 µm to 600 µm. The coefficient of thermal expansion of the semiconductor device 20 may be, for example, about 3 ppm/°C to 6 ppm/°C.

The semiconductor device 20 includes a semiconductor substrate 21, an electrode 22, an electrode 23, and an electrode 24. The electrode 23 is a control electrode of the semiconductor device 20. The semiconductor substrate 21 is formed of, for example, silicon (Si) or silicon carbide (SiC).

The electrodes 22 and 23 are formed on the upper surface of each semiconductor substrate 21. The electrodes 22 and 23 are situated apart from each other. The electrode 22 is, for example, substantially rectangular in plan view, and has a recess 22x setting back on one side. The electrode 23 may be located in the recesses 22x and spaced from the electrode 22 in plan view. The electrode 22 is, for example, the source electrode of the MOSFET. The electrode 23 is, for example, the gate electrode of the MOSFET. The electrode 24 is formed on the lower surface of each semiconductor substrate 21. The electrode 24 is, for example, the drain electrode of the MOSFET.

As the materials of the electrodes 22, 23, and 24, for example, a metal such as aluminum (Al) or copper (Cu), or an alloy containing at least one metal selected from these metals may be used. If necessary, the same surface treatment layer as previously described may be formed on the surfaces of the electrodes 22, 23, and 24.

Each semiconductor device 20 is arranged at a constant rotation angle relative to the adjacent semiconductor device 20. In the first embodiment, each semiconductor device 20 is arranged at a rotation angle of 90 degrees relative to the adjacent semiconductor device 20. That is, in FIG. 1A, the upper-right semiconductor device 20 is arranged at a clockwise rotation angle of 90 degrees relative to the upper-left semiconductor device 20. The lower-right semiconductor device 20 is arranged at a clockwise rotation angle of 90 degrees relative to the upper-right semiconductor device 20. The lower-left semiconductor device 20 is arranged at a clockwise rotation angle of 90 degrees relative to the lower-right semiconductor device 20. The upper-left semiconductor device 20 is arranged at a clockwise rotation angle of 90 degrees relative to the lower-left semiconductor device 20. Whether or not the semiconductor devices 20 are rotated may be confirmed by the positions of the electrodes 23 in plan view.

The interconnect substrate 30 is disposed on the semiconductor devices 20. The interconnect substrate 30 is formed in a flat plate shape. The interconnect substrate 30 may have any plane shape and any size. In the example illustrated in FIGS. 1A and 1B, the plane shape of the interconnect substrate 30 is rectangular. The thickness of the interconnect substrate 30 may be, for example, about 200 µm to 400 µm. The thermal expansion coefficient of the interconnect substrate 30 may be, for example, about 20 ppm/°C to 25 ppm/°C. For example, the interconnect substrate 30 may be provided such as to exactly overlap the interconnect substrate 10 in plan view.

The interconnect substrate 30 includes an insulating layer 31, an adhesive layer 32, and an interconnect layer 33. The insulating layer 31 is adhered to the semiconductor device 20 by the adhesive layer 32. As the material of the insulating layer 31, for example, an insulating resin such as a polyimide-based resin or a polyester-based resin may be used. The thickness of the insulating layer 31 may be, for example, about 30 µm to 100 µm.

The adhesive layer 32 is formed on the lower surface of the insulating layer 31. The thickness of the adhesive layer 32 may be, for example, about 20 µm to 45 µm. The adhesive layer 32 may be, for example, an epoxy-based, polyimide-based, or silicone-based adhesive. The adhesive layer 32 may be provided so as to encompass, for example, a part of the semiconductor device 20. In other words, a part of the semiconductor device 20 may be embedded in the adhesive layer 32. For example, the outer perimeter edges of the electrodes 22 and 23 of the semiconductor device 20 may be embedded in the adhesive layer 32. An upper part of the side surface of the semiconductor device 20 may be covered with the adhesive layer 32.

The interconnect substrate 30 has through-holes 30x formed through the insulating layer 31 and the adhesive layer 32 in the thickness direction. The through-holes 30x are each formed to expose a part of the upper surfaces of the electrodes 22 and 23, for example. The plane shape of each of the through-holes 30x is, for example, circular. One through-hole 30x may be provided at a position corresponding to each electrode.

The interconnect layer 33 is formed on one side of the insulating layer 31. The interconnect layer 33 may include interconnect patterns 331 and 332 arranged on the one side of the insulating layer 31. The interconnect patterns 331 and 332 are arranged on the opposite side from the semiconductor device 20 across the insulating layer 31. The interconnect patterns 331 and 332 each include a planar interconnect formed on the upper surface of the insulating layer 31 and via interconnects formed in the through-holes 30x. In the example of FIG. 1A, the interconnect pattern 331 is surrounded by the interconnect pattern 332 in plan view.

The interconnect pattern 331 connects the electrodes 23, which are the control electrodes of the semiconductor devices 20. The interconnect pattern 332 connects the electrodes 22 of the semiconductor devices 20. The metal layer 12 of the interconnect substrate 10 connects the electrodes 24 of the semiconductor devices 20. With this arrangement, the semiconductor devices 20 are connected in parallel with each other.

The interconnect pattern 331 includes the same number of interconnects of equal length as the semiconductor devices 20, and also includes a voltage input point I for inputting a voltage to the electrodes 23, which are the control electrodes of the semiconductor devices 20, via the interconnects of equal length. In FIG. 1A, the interconnects of equal length connect the voltage input point I with the electrodes 23. In other words, the voltage input point I is defined at the position equidistant from the electrodes 23. In the example illustrated in FIG. 1A, four L-shaped interconnects of equal length are connected to each other in the proximity of the voltage input point I in plan view, such that the interconnect pattern 331 has a swastika shape. The interconnects of equal length preferably has the same width.

As the material of the interconnect layer 33, for example, copper or a copper alloy may be used. If necessary, the same surface treatment layer as previously described may be formed on the surface (both the upper surface and the side surfaces, or only the upper surface) of the interconnect layer 33. The thermal expansion coefficient of the interconnect layer 33 may be, for example, about 15 ppm/°C to 18 ppm/°C. The thickness of the interconnect layer 33 may be, for example, about 50 µm to 200 µm.

In the present invention, when there are n semiconductor devices (n is a natural number equal to or greater than 3), the interconnect pattern 331 and the electrodes 23 serving as the control electrodes of the semiconductor devices 20 may have n-fold symmetry with respect to the voltage input point I in plan view. In the example illustrated in FIGS. 1A and 1B, there are four semiconductor devices 20, and the interconnect pattern 331 and the electrodes 23 serving as the control electrodes of the semiconductor devices 20 have 4-fold symmetry with respect to the voltage input point I in plan view.

The encapsulating resin 50 encapsulates the semiconductor device 20 provided between the interconnect substrate 10 and the interconnect substrate 30. As the material of the encapsulating resin 50, for example, a non-photosensitive insulating resin mainly composed of a thermosetting resin may be used. Specifically, the material of the encapsulating resin 50 may be, for example, an insulating resin such as an epoxy-based resin or a polyimide-based resin, or a resin material in which a filler such as silica or alumina is mixed with such a resin. As the encapsulating resin 50, for example, a mold resin may be used. The thermal expansion coefficient of the encapsulating resin 50 may be, for example, about 5ppm/°C to 18 ppm/°C. The metal layer 12 extends to the outside of the encapsulating resin 50 in order to enable electrical connection.

As described above, the semiconductor apparatus 1 is such that the electrodes 23 (e.g., the gate electrode of a MOSFET), which are the control electrodes of the semiconductor devices 20, are connected to the voltage input point I only through the equal length interconnects extending in different directions from the voltage input point I. That is, the interconnects connected from the voltage input point I to the electrodes 23, which are the control electrodes of the semiconductor devices 20, have the same length. This arrangement enables the reduction of timing deviation when the control voltage is input from the voltage input point I to the semiconductor devices 20 to cause the semiconductor devices 20 to be simultaneously switched. Furthermore, it is possible to equalize the currents flowing through the electrodes 24 (e.g., the drain electrode of a MOSFET) of the semiconductor devices 20. It may be noted that the equal-length interconnects connected from the voltage input point I to the electrodes 23 serving as the control electrodes of the respective semiconductor devices 20 may be made to have the same width, which further enhances the above-described advantageous effects.

In addition, the semiconductor devices 20 are preferably arranged at a constant rotation angle relative to the adjacent semiconductor devices 20, which allows the respective electrodes 23 to be easily connected to the voltage input point I through equal-length interconnects. When the semiconductor devices 20 are arranged at a rotation angle of 90 degrees relative to the adjacent semiconductor devices 20, the crystal orientations of the semiconductor devices 20 differ from each other, thereby serving to improve the apparent strength of the semiconductor apparatus 1.

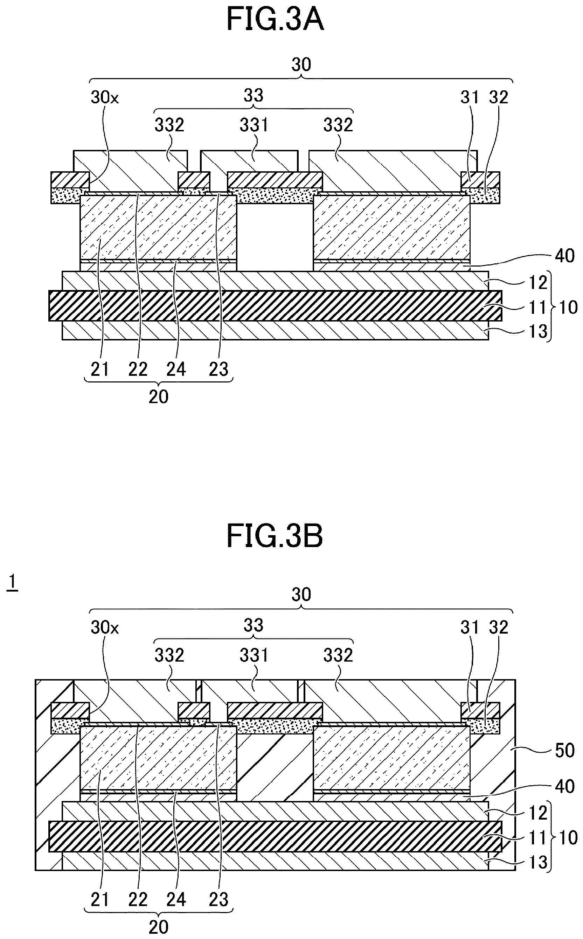

In the example illustrated in FIG. 3 of Patent Document 1, the control electrodes of semiconductor devices are not connected to a voltage input point only through equal-length interconnects extending in different directions from the voltage input point. In the example illustrated in FIG. 3 of Patent Document 1, the gate circuit pattern is configured by connecting an L-shaped portion 24a in plan view and an H-shaped portion 24b in plan view. This configuration is not preferable in that current concentration easily occurs in a semiconductor device. For example, at the time of turning off the semiconductor devices, current is temporarily concentrated in a semiconductor device with a low threshold voltage due to variations in the gate threshold voltage. In the configuration disclosed in Patent Document 1, the H-shaped portion 24b branches into two sections on the left and branches into two sections on the right. If there is a deviation that increases the threshold voltage in one of the two sections on either side, the current is likely to be concentrated in the other section. In such a case, the likelihood of oscillation increases.

On the other hand, the semiconductor apparatus 1 is such that the electrodes 23, which are the control electrodes of the semiconductor devices 20, are connected to the voltage input point I only through the respective equal-length interconnects extending in different directions from the voltage input point I, and the interconnect pattern 331 does not have branches as in Patent Document 1. With this arrangement, even when there is a deviation that increases the threshold voltage in one of the semiconductor devices 20, the other three semiconductor devices 20 are equally capable of receiving current. As a result, current concentration in a particular semiconductor device 20 is unlikely to occur, and oscillation is also unlikely to occur.

In addition, when branches exist as in the configuration of Patent Document 1, the resin needs to go around both sides of the branches when forming the encapsulating resin, so that voids are likely to be formed in the encapsulating resin. In the semiconductor apparatus 1, since the interconnect pattern 331 does not have branches as in Patent Document 1, resin flows easily, and voids are unlikely to be formed in the encapsulating resin.

The semiconductor apparatus 1 may not have the interconnect substrate 10. In this case, the metal layer 12 for connecting the electrodes 24 to each other is provided on the lower surface side of the semiconductor devices 20. In other words, the semiconductor apparatus 1 may have only the metal layer 12 instead of the interconnect substrate 10.

### [Method of Making a Semiconductor Apparatus]

In the following, a method of making the semiconductor apparatus 1 will be described. For convenience of explanation, parts that eventually become the respective components of the semiconductor apparatus 1 will be designated by the reference numerals of the final components.

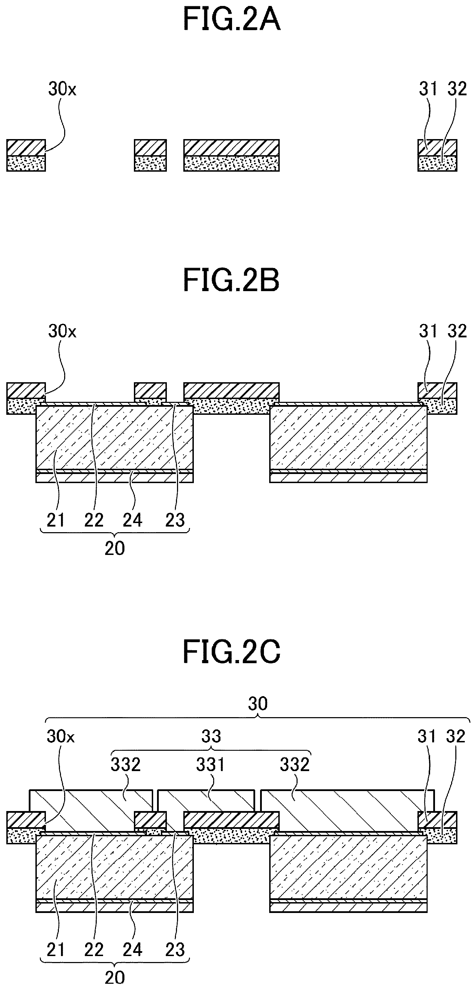

First, in a step illustrated in FIG. 2A, an insulating layer 31 in a sheet form is prepared, and an adhesive layer 32 is formed on the lower surface of the insulating layer 31. Through-holes 30x are then formed in required portions of the insulating layer 31 and the adhesive layer 32. The through-holes 30x may be formed by a laser processing method using, for example, a CO₂ laser or a UV-YAG laser.

Next, in a step illustrated in FIG. 2B, semiconductor devices 20 are fixed to the lower surface of the insulating layer 31 through the adhesive layer 32. When the semiconductor devices 20 are fixed, the upper surfaces of the electrodes 22 and 23 are partially exposed in the through-holes 30x.

In a step illustrated in FIG. 2C, an interconnect layer 33 is formed on the insulating layer 31. With this, the fabrication of the interconnect substrate 30 having the insulating layer 31, the adhesive layer 32, and the interconnect layer 33 is completed. The interconnect layer 33 includes the interconnect patterns 331 and 332 arranged on the same side of the insulating layer 31. The interconnect pattern 331 is electrically connected to the electrodes 23, and the interconnect pattern 332 is electrically connected to the electrodes 22. The interconnect patterns 331 and 332 are formed in the pattern illustrated in FIG. 1A. The interconnect patterns 331 and 332 each include a planar interconnect formed on the upper surface of the insulating layer 31 and via interconnects formed in the through-holes 30x. The interconnect patterns 331 and 332 may be formed by various interconnect forming methods such as a semi-additive method.

In a step illustrated in FIG. 3A, an interconnect substrate 10 having a metal layer 12 formed on the upper surface and a metal layer 13 formed on the lower surface is prepared. Then, joints 40 are formed on the upper surface of the metal layer 12. Specifically, the joints 40 are formed at four locations where the semiconductor devices 20 illustrated in FIG. 1 are arranged. The joints 40 may be formed by applying, for example, a sintered material in paste form (i.e., sintering paste) by a printing method or a dispenser method. As the sintering paste, for example, silver sintering paste in which silver particles are dispersed in an organic solvent may be used. As the printing method, for example, a screen printing method or a stencil printing method may be used.

Subsequently, the semiconductor devices 20 mounted on the interconnect substrate 30 are placed on the upper surfaces of the respective joints 40. Specifically, the semiconductor devices 20 are placed on the upper surfaces of the joints 40 such that the electrodes 24 formed on the lower surfaces of the semiconductor devices 20 are in contact with the upper surfaces of the joints 40.

The joints 40 are then sintered by heating the joints 40. As a result, the metal layer 12 and the electrodes 24 of the semiconductor devices 20 are joined by the joints 40. That is, the semiconductor devices 20 are joined on the metal layer 12 via the joints 40. The electrodes 24 of the semiconductor devices 20 are connected in parallel via the metal layer 12.

In a step illustrated in FIG. 3B, an encapsulating resin 50 for encapsulating the semiconductor devices 20 provided between the interconnect substrate 10 and the interconnect substrate 30 is formed. The encapsulating resin 50 may be formed, for example, in such a manner as to expose the upper surface of the interconnect layer 33 and the lower surface of the metal layer 13 and cover the other surfaces. The encapsulating resin 50 may be formed, for example, by using a method such as a transfer molding method, a compression molding method, or an injection molding method. Through the steps described above, the fabrication of the semiconductor apparatus 1 is completed.

### <Variations of First Embodiment>

Variations of the first embodiment are directed to examples of a semiconductor apparatus different from the first embodiment in the number of semiconductor devices, the shape of interconnect patterns, or the like. With respect to these variations of the first embodiment, descriptions of the same components as those of the already described embodiment may be omitted as appropriate.

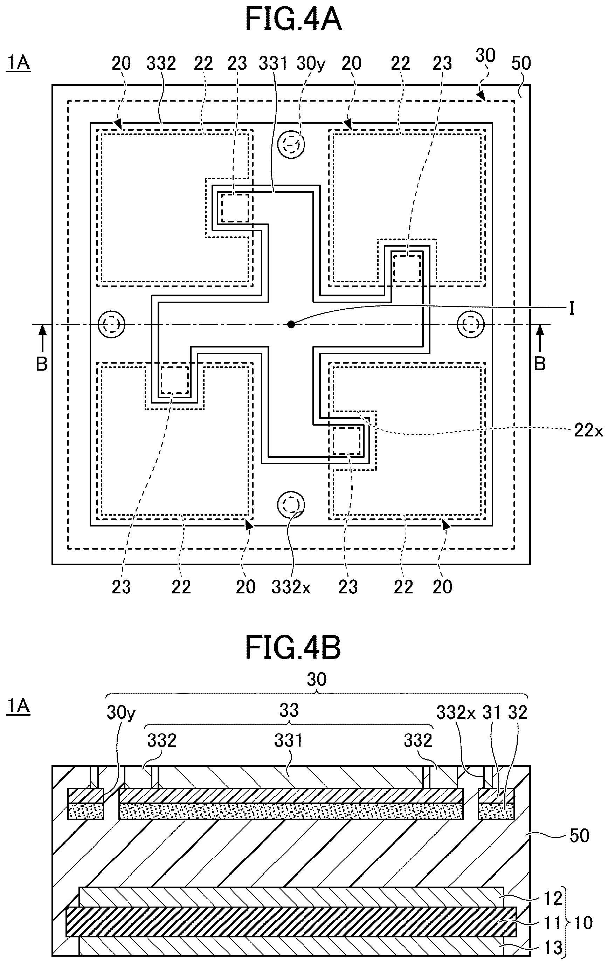

FIGS. 4A and 4B are drawings illustrating a semiconductor apparatus according to a first variation of the first embodiment. FIG. 4A is a plan view, and FIG. 4B is a cross-sectional view taken along the line B-B in FIG. 4A. Referring to FIGS. 4A and 4B, a semiconductor apparatus 1A differs from the semiconductor apparatus 1 in that degas holes 30y are formed through the interconnect substrate 30.

The degas holes 30y are holes for degassing. Through-holes 332x are provided at those portions of the interconnect pattern 332 which overlap the degas holes 30y in plan view. That is, the degas holes 30y are provided at positions where the degas holes do not overlap with the interconnect patterns 331 and 332 in plan view. The degas holes 30y are filled with the encapsulating resin 50. In the example illustrated in FIGS. 4A and 4B, four degas holes 30y are provided, but the number of degas holes y may be any number that is greater than or equal to one.

By providing the degas holes 30y in the interconnect substrate 30, gas generated in the semiconductor apparatus 1A during heating may be released to the outside in the step of forming the encapsulating resin 50 of the semiconductor apparatus 1A. This may reduce the risk of voids occurring in the encapsulating resin 50.

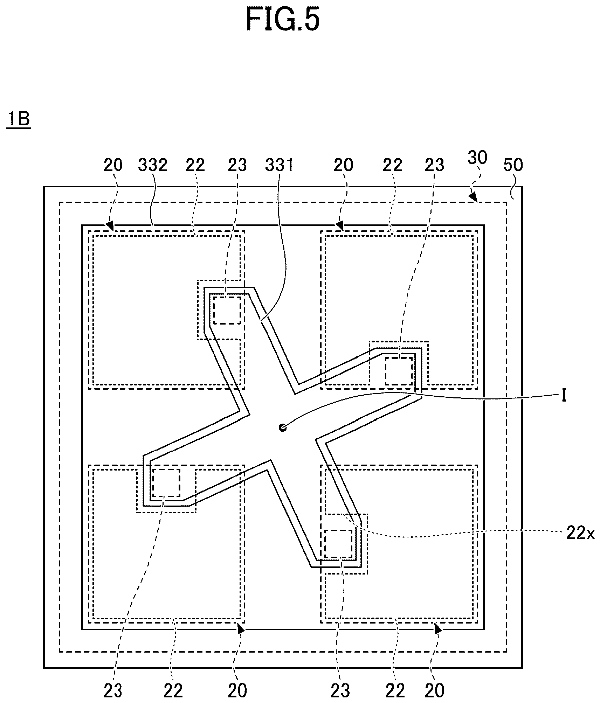

FIG. 5 is a plan view illustrating a semiconductor apparatus according to a second variation of the first embodiment, which does not form part of the invention. Referring to FIG. 5, a semiconductor apparatus 1B differs from the semiconductor apparatus 1 in the shape of the interconnect pattern 331.

In the semiconductor apparatus 1B, in plan view, four linear equal-length interconnects are connected together in the proximity of the voltage input point I, and the interconnect pattern 331 has a cross shape. The voltage input point I is located at the center of the cross. In plan view, all imaginary straight lines connecting the center of each of the electrodes 23 of the semiconductor devices 20 to the voltage input point I overlap with the interconnect pattern 331.

By forming the interconnect pattern 331 into a cross shape, the distance between the voltage input point I and each electrode 23 may be made to be the shortest. This arrangement further reduces the timing deviation when the control voltage is input from the voltage input point I to each semiconductor device 20 to cause the simultaneous switching operation of each semiconductor device 20.

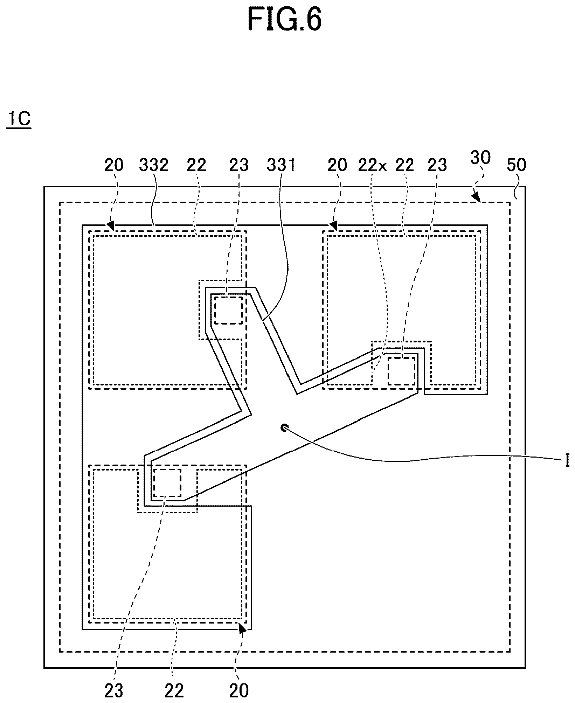

FIG. 6 is a plan view illustrating a semiconductor apparatus according to a third variation of the first embodiment, which does not form part of the invention. Referring to FIG. 6, a semiconductor apparatus 1C differs from the semiconductor apparatus 1 having the four semiconductor devices 20 in that three semiconductor devices 20 are provided.

As described above, the semiconductor apparatus may include three semiconductor devices 20. In the semiconductor apparatus 1C, three equal-length linear interconnects are connected together in the proximity of the voltage input point I in plan view, and the interconnect pattern 331 is T-shaped. The semiconductor apparatus 1C provides the same advantageous effects as the semiconductor apparatus 1B.

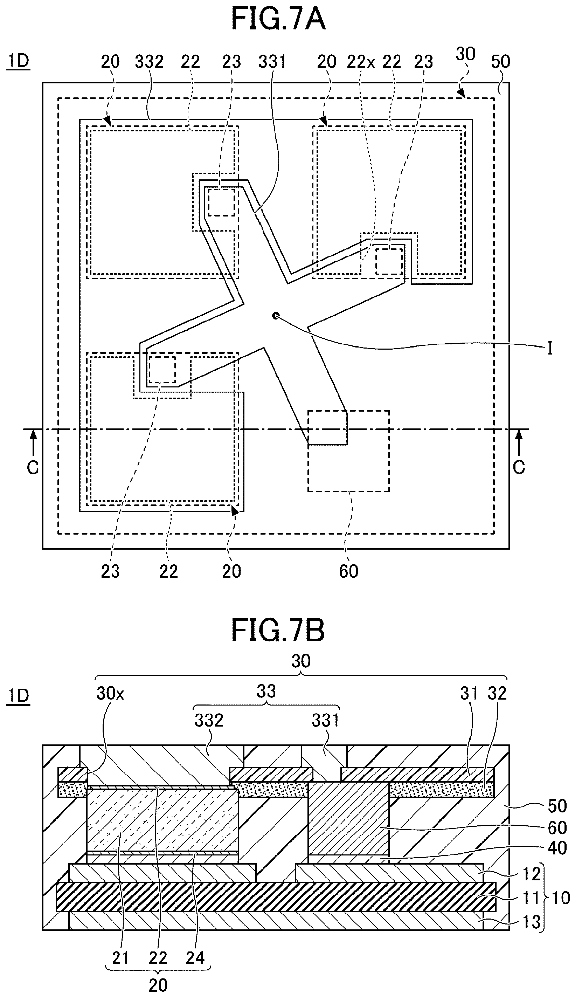

FIGS. 7A and 7B are drawings illustrating a semiconductor apparatus according to a fourth variation of the first embodiment, which does not form part of the invention; FIG. 7A is a plan view, and FIG. 7B is a cross-sectional view taken along the line C-C in FIG. 7A. Referring to FIGS. 7A and 7B, a semiconductor apparatus 1D differs from the semiconductor apparatus 1 in that a connecting member 60 is provided.

The lower surface of the connecting member 60 is electrically connected to the metal layer 12 of the interconnect substrate 10 via the joint 40. It may be noted that, the connecting member 60 is connected to an interconnect pattern of the metal layer 12 different from the interconnect patterns connected to the electrodes 24 of the semiconductor devices 20. The upper surface of the connecting member 60 is electrically connected to the interconnect pattern 331 of the interconnect substrate 30. Thus, the interconnect pattern 331 is electrically connected to the metal layer 12 via the connecting member 60.

The connecting member 60 is, for example, a columnar shape extending in the thickness direction of the semiconductor apparatus 1D. The connecting member 60 is, for example, a metal post. As the material of the connecting member 60, for example, copper or a copper alloy may be used. The connecting member 60 may be, for example, substantially the same thickness as the semiconductor device 20. The thickness of the connecting member 60 may be, for example, approximately 50 µm to 600 µm. The upper surface of the connecting member 60 may be, for example, flush with the upper surfaces of the electrodes 22 and 23 of the semiconductor devices 20.

As described above, the interconnect pattern 331 of the interconnect substrate 30 may include an interconnect electrically connected to the metal layer 12 via the connecting member 60. That is, the connecting member 60 may be arranged in a region where the semiconductor device 20 is not arranged in plan view so as to connect the interconnect pattern 331 of the interconnect substrate 30 and the metal layer 12 of the interconnect substrate 10. The length of the interconnect may not be equal to the length of the three equal length interconnects. A voltage is input into the voltage input point I via the metal layer 12 and the connecting member 60.

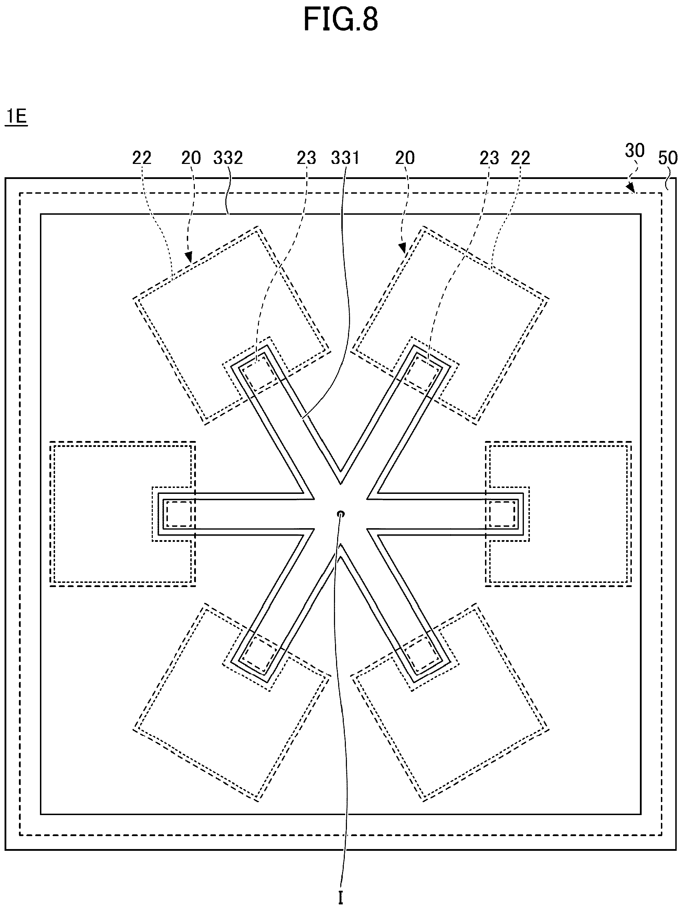

FIG. 8 is a plan view illustrating a semiconductor apparatus according to a fifth variation of the first embodiment, which does not form part of the invention. Referring to FIG. 8, a semiconductor apparatus 1E differs from the semiconductor apparatus 1 having the four semiconductor devices 20 in that six semiconductor devices 20 are provided.

As described above, the semiconductor apparatus may have six semiconductor devices 20. In the semiconductor apparatus 1E, in plan view, six linear equal length interconnects are connected together in the proximity of the voltage input point I. In plan view, the interconnect pattern 331 and the electrodes 23, which are the control electrodes of the semiconductor devices 20, have 6-fold symmetry with respect to the voltage input point I and also have 12-fold symmetry. The semiconductor apparatus 1E provides the same advantageous effects as the semiconductor apparatus 1B.

According to at least one embodiment, a semiconductor apparatus is provided that may reduce timing deviation when a plurality of semiconductor devices need to be simultaneously switched.

## Claims

1. A semiconductor apparatus (1, 1A), comprising:
three or more semiconductor devices (20) connected in parallel with each other, and
an interconnect substrate (30) arranged on the semiconductor devices (20),
wherein the semiconductor devices (20) have respective control electrodes (23) and are switched by a voltage applied to the control electrodes (23),
wherein the interconnect substrate (30) includes:
an insulating layer (31); and
a first interconnect pattern (331) arranged on an opposite side of the insulating layer (31) from the semiconductor devices (20) and connecting the control electrodes (23) of the semiconductor devices (20),
wherein the first interconnect pattern (331) includes a same number of interconnects of equal length as the semiconductor devices (20), and a voltage input point (I) configured to receive a voltage applied to the control electrodes (23) of the semiconductor devices (20) via the interconnects of equal length, and
wherein the control electrodes (23) of the semiconductor devices (20) are connected to the voltage input point (I) only by the interconnects of equal length, which extend in different directions from the voltage input point (I),
the semiconductor apparatus (1, 1A) being **characterized in that**
a number of semiconductor devices (20) is four, and in plan view, the first interconnect pattern (331) is a swastika shape.

2. The semiconductor apparatus (1, 1A) as claimed in claim **1,** wherein each of the semiconductor devices (20) is arranged at a predetermined rotation angle relative to an adjacent one of the semiconductor devices.

3. The semiconductor apparatus (1, 1A) as claimed in claim 1, wherein in plan view, all imaginary straight lines connecting a center of each of the control electrodes (23) of the semiconductor devices (20) to the voltage input point (I) overlap with the first interconnect pattern (331).

4. The semiconductor apparatus (1, 1A) as claimed in claim 1, wherein the first interconnect pattern (331) and the control electrodes (23) of the semiconductor devices (20) have four-fold symmetry with respect to the voltage input point (I).

5. The semiconductor apparatus (1, 1A) as claimed in any one of claims 1 to 4, further comprising a metal layer (12) on a lower surface side of the semiconductor devices (20),
wherein the semiconductor devices (20) include:
respective semiconductor substrates (21);
respective first electrodes (22) and the respective control electrodes (23) formed on upper surfaces of the semiconductor substrates (20); and
respective second electrodes (24) formed on lower surfaces of the semiconductor substrates (21),
wherein the interconnect substrate (30) includes a second interconnect pattern (332) connecting the first electrodes (22) to each other and arranged on a same side of the insulating layer (31) as the first interconnect pattern (331), and
wherein the metal layer (12) connects the second electrodes (24) to each other.

6. The semiconductor apparatus (1, 1A) as claimed in claim 5, wherein in plan view, the first interconnect pattern (331) is surrounded by the second interconnect pattern (332), and
wherein the first interconnect pattern (331) and the second interconnect pattern (332) each include a planar interconnect formed on an upper surface of the insulating layer (31) and via interconnects formed in through-holes (30x) formed through the insulating layer.

7. The semiconductor apparatus (1, 1A) as claimed in claim 5, further comprising an insulating layer (11) on which the metal layer (12) is formed.

8. The semiconductor apparatus (1, 1A) as claimed in any one of claims 1 to 4, wherein the interconnect substrate (30) has a degas hole (30y) passing therethrough.

9. The semiconductor apparatus (1, 1A) as claimed in any one of claims 1 to 8, wherein an entirety of the first interconnect pattern (331) is a swastika shape.

## Patentansprüche

1. Halbleitervorrichtung (1, 1A), umfassend:
drei oder mehr Halbleitervorrichtungen (20), die miteinander parallel geschaltet sind, und
ein Zusammenschaltungssubstrat (30), das auf den Halbleitervorrichtungen (20) angeordnet ist,
wobei die Halbleitervorrichtungen (20) jeweilige Steuerelektroden (23) aufweisen und durch eine Spannung geschaltet werden, die an die Steuerelektroden (23) angelegt wird,
wobei das Zusammenschaltungssubstrat (30) umfasst:
eine Isolationsschicht (31); und
eine erste Zusammenschaltungsstruktur (331), die auf einer den Halbleitervorrichtungen (20) entgegengesetzten Seite der Isolationsschicht (31) angeordnet ist und die Steuerelektroden (23) der Halbleitervorrichtungen (20) verbindet,
wobei die erste Zusammenschaltungsstruktur (331) eine gleiche Anzahl von Zusammenschaltungen mit gleicher Länge wie die Halbleitervorrichtungen (20) und einen Spannungseingangspunkt (I) umfasst, der dazu ausgestaltet ist, eine Spannung zu empfangen, die an die Steuerelektroden (23) der Halbleitervorrichtungen (20) über die Zusammenschaltungen mit gleicher Länge angelegt wird, und
wobei die Steuerelektroden (23) der Halbleitervorrichtungen (20) mit dem Spannungseingangspunkt (I) lediglich mittels der Zusammenschaltungen mit gleicher Länge verbunden sind, die sich in unterschiedlichen Richtungen von dem Spanungseingangspunkt (I) erstrecken,
die Halbleitervorrichtung (1, 1A) **dadurch gekennzeichnet ist, dass**
eine Anzahl von Halbleitervorrichtungen (20) vier beträgt und in der Draufsicht die erste Zusammenschaltungsstruktur (331) eine Hakenkreuzform ist.

2. Halbleitervorrichtung (1, 1A) nach Anspruch 1, wobei jede der Halbleitervorrichtungen (20) in einem vorbestimmten Drehwinkel in Bezug auf eine benachbarte der Halbleitervorrichtungen angeordnet ist.

3. Halbleitervorrichtung (1, 1A) nach Anspruch 1, wobei in einer Draufsicht sämtliche gedachten geraden Linien, die eine Mitte von jeder der Steuerelektroden (23) der Halbleitervorrichtungen (20) mit dem Spannungseingangspunkt (I) verbinden, sich mit der ersten Zusammenschaltungsstruktur (331) überlappen.

4. Halbleitervorrichtung (1, 1A) nach Anspruch 1, wobei die erste Zusammenschaltungsstruktur (331) und die Steuerelektroden (23) der Halbleitervorrichtungen (20) vierfache Symmetrie in Bezug auf den Spannungseingangspunkt (I) aufweisen.

5. Halbleitervorrichtung (1, 1A) nach einem der Ansprüche 1 bis 4, ferner umfassend eine Metallschicht (12) auf einer Seite einer unteren Oberfläche der Halbleitervorrichtungen (20),
wobei die Halbleitervorrichtungen (20) umfassen:
jeweilige Halbleitersubstrate (21);
jeweilige erste Elektroden (22) und die jeweiligen Steuerelektroden (23), die auf oberen Oberflächen der Halbleitersubstrate (20) gebildet sind; und
jeweilige zweite Elektroden (24), die auf unteren Oberflächen der Halbleitersubstrate (21) gebildet sind,
wobei das Zusammenschaltungssubstrat (30) eine zweite Zusammenschaltungsstruktur (332) umfasst, welche die ersten Elektroden (22) miteinander verbindet und auf einer gleichen Seite der Isolationsschicht (31) angeordnet ist wie die erste Zusammenschaltungsstruktur (331), und
wobei die Metallschicht (12) die zweiten Elektroden (24) miteinander verbindet.

6. Halbleitervorrichtung (1, 1A) nach Anspruch 5, wobei in der Draufschicht die erste Zusammenschaltungsstruktur (331) von der zweiten Zusammenschaltungsstruktur (332) umgeben ist, und
wobei die erste Zusammenschaltungsstruktur (331) und die zweite Zusammenschaltungsstruktur (332) jeweils eine ebene Zusammenschaltung, die auf einer oberen Oberfläche der Isolationsschicht (31) gebildet ist, und Durchkontaktierungszusammenschaltungen umfassen, die in Durchgangslöchern (30x) gebildet sind, die durch die Isolationsschicht gebildet sind.

7. Halbleitervorrichtung (1, 1A) nach Anspruch 5, ferner umfassend eine Isolationsschicht (11), auf der die Metallschicht (12) gebildet ist.

8. Halbleitervorrichtung (1, 1A) nach einem der Ansprüche 1 bis 4, wobei das Zusammenschaltungssubstrat (30) eine Entgasungsöffnung (30y) aufweist, die dieses durchquert.

9. Halbleitervorrichtung (1, 1A) nach einem der Ansprüche 1 bis 8, wobei eine Gesamtheit der ersten Zusammenschaltungsstruktur (331) eine Hakenkreuzform ist.

## Revendications

1. Appareil à semi-conducteur (1, 1A), comprenant :
trois ou plus dispositifs à semi-conducteur (20) connectés en parallèle les uns aux autres, et
un substrat d'interconnexion (30) disposé sur les dispositifs à semi-conducteur (20),
dans lequel les dispositifs à semi-conducteur (20) ont des électrodes de commande respectives (23) et sont commutés par une tension appliquée aux électrodes de commande (23),
dans lequel le substrat d'interconnexion (30) comprend :
une couche isolante (31) ; et
un premier motif d'interconnexion (331) disposé sur un côté opposé de la couche isolante (31) par rapport aux dispositifs à semi-conducteur (20) et connectant les électrodes de commande (23) des dispositifs à semi-conducteur (20),
dans lequel le premier motif d'interconnexion (331) comprend un même nombre d'interconnexions de longueur que les dispositifs à semi-conducteur (20), et un point d'entrée de tension (I) configuré pour recevoir une tension appliquée aux électrodes de commande (23) des dispositifs à semi-conducteur (20) via les interconnexions de longueur égale, et
dans lequel les électrodes de commande (23) des dispositifs à semi-conducteur (20) sont connectées au point d'entrée de tension (I) uniquement par les interconnexions de longueur égale, qui s'étendent dans des directions différentes à partir du point d'entrée de tension (I),
l'appareil à semi-conducteur (1, 1A) étant **caractérisé en ce que**
un nombre de dispositifs à semi-conducteurs (20) est égal à quatre, et dans une vue en plan, le premier motif d'interconnexion (331) a la forme d'une croix gammée.

2. Appareil à semi-conducteur (1, 1A) selon la revendication 1, dans lequel chacun des dispositifs à semi-conducteur (20) est disposé selon un angle de rotation prédéterminé par rapport à un dispositif à semi-conducteur adjacent.

3. Appareil à semi-conducteur (1, 1A) selon la revendication 1, dans lequel, en vue en plan, toutes lignes droites imaginaires reliant un centre de chacune des électrodes de commande (23) des dispositifs à semi-conducteur (20) au point d'entrée de tension (I) se superposent au premier motif d'interconnexion (331).

4. Appareil à semi-conducteur (1, 1A) selon la revendication 1, dans lequel le premier motif d'interconnexion (331) et les électrodes de commande (23) des dispositifs à semi-conducteur (20) présentent une symétrie quadruple par rapport au point d'entrée de tension (I).

5. Appareil à semi-conducteur (1, 1A) selon l'une quelconque des revendications 1 à 4, comprenant en outre une couche métallique (12) sur une surface inférieure des dispositifs à semi-conducteur (20),
dans lequel les dispositifs à semi-conducteur (20) comprennent :
des substrats semi-conducteurs respectifs (21) ;
des premières électrodes respectives (22) et les électrodes de commande respectives (23) formées sur des surfaces supérieures des substrats semi-conducteurs (20) ; et
des secondes électrodes respectives (24) formées sur des surfaces inférieures des substrats semi-conducteurs (21),
dans lequel le substrat d'interconnexion (30) comprend un deuxième motif d'interconnexion (332) reliant les premières électrodes (22) les unes aux autres et disposé sur un même côté de la couche isolante (31) que le premier motif d'interconnexion (331), et
dans lequel la couche métallique (12) relie les secondes électrodes (24) les unes aux autres.

6. Appareil à semi-conducteur (1, 1A) selon la revendication 5, dans lequel, en vue en plan, le premier motif d'interconnexion (331) est entouré par le deuxième motif d'interconnexion (332), et
dans lequel le premier motif d'interconnexion (331) et le deuxième motif d'interconnexion (332) comprennent chacun une interconnexion plane formée sur une surface supérieure de la couche isolante (31) et des interconnexions de via formées dans des orifices traversants (30x) formés à travers la couche isolante.

7. Appareil à semi-conducteur (1, 1A) selon la revendication 5, comprenant en outre une couche isolante (11) sur laquelle est formée la couche métallique (12).

8. Appareil à semi-conducteur (1, 1A) selon l'une quelconque des revendications 1 à 4, dans lequel le substrat d'interconnexion (30) comporte un orifice de dégazage (30y) traversant.

9. Appareil à semi-conducteur (1, 1A) selon l'une quelconque des revendications 1 à 8, dans lequel une totalité du premier motif d'interconnexion (331) a une forme de croix gammée.
